# EUROPÄISCHE PATENTANMELDUNG

(11) **EP 1 791 412 A2**
(43) Veröffentlichungstag der Anmeldung: **30.05.2007**
(21) Anmeldenummer: 06016893.7
(22) Anmeldetag: 12.08.2006
(51) Int. Cl.: H05K 7/14

(54) **Kopf- oder Bodenteil eines Baugruppenträgers**

(30) Priorität: 24.11.2005 DE 102005056380
(71) Anmelder: Rittal Res Electronic Systems GmbH & Co. KG, 35745 Herborn (DE)
(72) Erfinder: Waltz, Eike, Aptos, CA 95503 (US); Körber, Werner, 91282 Betzenstein (DE); Schaffer, Kurt, 90542 Eckental (DE)
(74) Vertreter: Fleck, Hermann-Joseph

(57) **Zusammenfassung**

Die Erfindung betrifft ein Kopf- oder Bodenteil eines Baugruppenträgers mit nebeneinander angeordneten und in Einschubrichtung ausgerichteten Führungsschienen zur Aufnahme einer Leiterplatte einer Steckbaugruppe, wobei die Führungsschienen durch einstückige Führungselemente des Kopf- oder Bodenteils gebildet sind, und wobei das Kopf- oder Bodenteil zumindest bereichsweise aus einem elektrisch leitenden Material besteht.

Ist die Ausgestaltung so, dass das Kopf- oder Bodenteil zumindest teilweise im Bereich der Führungsschiene mit einer Oberflächenbeschichtung aus elektrisch nicht leitendem Material versehen ist, dann kann auf einfache Weise kostengünstig eine zuverlässige Isolierung der Leiterplatte gegenüber dem Kopf- bzw. Bodenteil erreicht werden.

## Beschreibung

Die Erfindung betrifft ein Kopf- oder Bodenteil eines Baugruppenträgers mit nebeneinander angeordneten und in Einschubrichtung ausgerichteten Führungsschienen zur Aufnahme einer Leiterplatte einer Steckbaugruppe, wobei die Führungsschienen durch einstückige Führungselemente des Kopf- oder Bodenteils gebildet sind, und wobei das Kopf- oder Bodenteil zumindest bereichsweise aus einem elektrisch leitenden Material besteht.

Ein derartiges Kopf- oder Bodenteil für einen Baugruppenträger ist aus der EP 1 144 579 A1 bekannt. Die Führungsschienen sind Bestandteile der Kopf- oder Bodenteile. Damit lässt sich die Anzahl der Aufbauteile für den Baugruppenträger beachtlich reduzieren. Zudem wird dadurch auch der Montageaufwand verringert. Die früher üblichen einsetzbaren getrennten Führungsschienen, wie sie z. B. bei einem Baugruppenträger nach der WO 00/2879 erforderlich sind, können entfallen.

Ein weiterer Vorteil dieser Kopf- oder Bodenteile besteht darin, dass bei der Anordnung einer Kühleinheit unter dem Bodenteil Kühlluft durch das Bodenteil gelangen und die Steckbaugruppen kühlen kann.

Diese Vorteile der bekannten Kopf- oder Bodenteile werden dadurch erkauft, dass deren Herstellung sehr kompliziert und teuer ist, denn die Führungsschienen bestehen aus Boden und zwei Seitenwänden und sind daher mit den Ausbuchtungen und Kontaktstellen zu den Leiterplatten der Steckbaugruppen nicht in einem einfachen Stanz-Biege-Vorgang herstellbar. Mitunter ist es gefordert, dass die Leiterplatten der Steckbaugruppen gegenüber den Führungsschienen elektrisch isoliert sind. Aus diesem Grund werden Kunststoffträger in die Führungsschienen eingesetzt, die den Rand der Leiterplatte aufnehmen. Die Kunststoffträger erhöhen den Teile- und Montageaufwand.

Es ist Aufgabe der Erfindung, ein Kopf- oder Bodenteil für einen Baugruppenträger der eingangs erwähnten Art so auszubilden, dass die Leiterplatte einer Steckbaugruppe auf einfache Weise gegenüber dem Kopf- oder Bodenteil elektrisch isoliert werden kann.

Diese Aufgabe wird nach der Erfindung dadurch gelöst, dass das Kopf- oder Bodenteil zumindest teilweise im Bereich der Führungsschiene mit einer Oberflächenbeschichtung aus elektrisch nicht leitendem Material versehen ist.

Mit der Oberflächenbeschichtung können selektiv gezielt Oberflächenbereiche des Kopf- oder Bodenteils elektrisch isoliert werden. Die Beschichtung kann günstig erstellt werden. Ein weiterer Vorteil ist, dass anwenderseitig keine zusätzlichen Montageschritte für die Erzeugung der Isolierung vorgenommen werden müssen. Darüber hinaus kann die Oberflächenbeschichtung mit geringer Schichtdicke ausgeführt werden, so dass wenig Montage- bzw. Luftführungsraum verloren geht.

Gemäß einer bevorzugten Ausgestaltung der Erfindung ist es vorgesehen, dass die Oberflächenbeschichtung stoffschlüssig mit der Oberfläche des Boden- und/oder Kopfteiles verbunden ist, wobei die Oberflächenbeschichtung beispielsweise als Pulverbeschichtung oder als Wirbelsinterbeschichtung ausgebildet sein kann. Diese Art der Beschichtung garantiert dauerhaft eine zuverlässige elektrische Isolation.

Gemäß einer bevorzugten Erfindungsausgestaltung kann es vorgesehen sein, dass die Führungselemente pro Führungsschienen aus jeweils zwei in Einschubrichtung verlaufenden beabstandeten Reihen von mehreren Führungsstegen gebildet sind, die aus einem plattenförmigen Kopf- oder Bodenteil ausgestanzt und zur Unterseite des Kopfteils oder zur Oberseite des Bodenteils vorstehend abgekantet sind, dass der Abstand der Führungsstege der Führungsschienen an die Dicke der Leiterplatten der Steckbaugruppen angepasst ist und dass das Kopf- oder Bodenteil zwischen den Reihen von Führungsstegen der Führungsschienen Führungsbahnen für die Leiterplatten der Steckbaugruppen bilden.

Die Führungsstege als Führungselemente können in einem einfachen Stanz-Biege-Vorgang aus einem plattenförmigen Basisteil hergestellt werden. Dabei bilden die Führungsstege keine oder keine großen Gegenkräfte, so dass die Steckbaugruppen leicht eingesteckt werden können.

Damit sich die Leiterplatten beim Ein- bzw. Ausschieben nicht verhaken, kann gemäß einer möglichen Erfindungsvariante vorgesehen sein, dass sich der Abstand zwischen den Führungsstegen zu den freien Endkanten der Führungsstege hin leicht vergrößert. Die Führungsbahn zwischen den Führungsstegen stellt eine zuverlässige Abstützung und Führung der Leiterplatte sicher.

Eine zuverlässige Isolierung kann bei einer solchen Anordnung insbesondere dadurch erreicht werden, dass die Führungsbahnen und die Führungsstege an ihren der Führungsbahnen zugewandten Seite mit der Oberflächenbeschichtung versehen sind.

Damit die Belüftung und Kühlung der Steckbaugruppen von der Unterseite her beibehalten werden kann, sieht eine weitere Ausgestaltung vor, dass außerhalb der Führungsbahnen und Führungsstege das Kopf- oder Bodenteil mittels Durchbrüchen lochblechartig ausgebildet ist. Diese Durchbrüche werden bevorzugt im gleichen Stanzvorgang wie die Führungsstege eingebracht.

Ist nach einer Ausgestaltung vorgesehen, dass die Seiten des plattenartigen Kopf-oder Bodenteils mittels abgekanteter Seitenwände versteift sind, dann kann schon mit reduzierter Wandstärke des Kopf- oder Bodenteils eine ausreichende Stabilität erreicht werden.

Wenn dabei zusätzlich vorgesehen ist, dass die Seitenwände zumindest bereichsweise von der Oberflächenbeschichtung freigestellt sind, dann können Bauteile des Baugruppenträgers, die an die Seitenwände angeschlossen sind (beispielsweise Seitenteile) über die leitende Bereiche auf ein einheitlich elektrisches Potential gelegt werden.

Des Weiteren kann über diese Bereiche den EMV-Anforderungen Rechnung getragen werden. Ist für den Baugruppenträger ein Kopf- und ein Bodenteil mit Führungsschienen vorgesehen, dann kann der Aufwand für die beiden Teile dadurch noch reduziert werden, dass das Kopf- und Bodenteil identisch ausgebildet und um 180° verdreht im Baugruppenträger eingebaut sind.

Eine besonders gute Führung und Kontaktierung der Leiterplatte in der Führungsschiene wird dadurch erreicht, dass die Führungselemente der Führungsbahnen eines Kopf- oder Bodenteiles in einem Baugruppenträger paarweise einander gegenüberstehend angeordnet sind.

Ist nach einer bevorzugten Ausgestaltung vorgesehen, dass das der Einführseite zugewandte erste Paar der Führungsstege einer Führungsbahn als Einführstege mit den einander zugekehrten Seiten im spitzen Winkel zueinander stehen, der sich zur Einführseite hin öffnet und dass die Einführstege der Führungsbahnen damit eine mit Einführschräge versehene Einführaufnahme bilden, dann wird schon beim Ansetzen der Steckbaugruppe an den Anfang einer Führungsschiene eine Art Zwangspositionierung und Einführung in die Führungsschiene erhalten. Dies erleichtert das Bestücken des Baugruppenträgers.

Das Kopf- oder Bodenteil ist vorzugsweise als Stanz-Biegeteil aus einem Stahlblechzuschnitt hergestellt. Dann kann es einfach hergestellt werden und zur Kontaktierung und Erdung bzw. Abschirmung der Steckbaugruppen mit verwendet werden.

Die Kontaktierung der Leiterplatte der Steckbaugruppe lässt sich einfach dadurch erreichen, dass auf einen der Einführstege ein Federelement aufsetzbar ist, das mit einem Federblatt in die Führungsschiene ragt. Dabei wird der Aufsteckvorgang einfach dadurch erleichtert, dass das Federelement eine Aufsteckhaube aufweist, die auf den Querschnitt des Einführelementes angepasst ist.

Die Festlegung des Federelementes auf dem Einführsteg geschieht in der Weise, dass sich an die Aufsteckhaube des Federelementes ein U-förmiges Steckteil anschließt, das zwei Schenkel mit Rastlappen aufweist, und dass das Steckteil in die beim Ausstanzen und Abkanten des Einführsteges entstehende Stanzaufnahme des Kopf- oder Bodenteils einrastbar ist. Der Einrast- und Aufsetzvorgang wird eindeutig ohne Verkanten des Federelementes dadurch sichergestellt, dass das Steckteil in einen abgewinkelten Endanschlag ausläuft, der die Einsteckbewegung des Steckteils und die Aufsteckbewegung der Aufsteckhaube begrenzt. Der Endabschnitt des Steckteils liegt dabei auf der Unter- oder Oberseite von Kopf- oder Bodenteil an, je nachdem auf welchem Teil das Federelement festgelegt wird.

Das in die Führungsschiene ragende Federblatt erschwert dann das Herausziehen der Steckbaugruppe nicht, wenn vorgesehen ist, dass das Federblatt eine Anlagekontaktstelle zur Leiterplatte der Steckbaugruppe bildet und dass das Federblatt nach der Anlagekontaktstelle in einen eine Anziehschräge bildenden Endabschnitt übergeht. Die Ausziehschräge stellt sicher, dass sich der Endabschnitt des Federblattes nicht an den Führungsstegen verhaken kann.

Die Erfindung wird anhand eines in den Zeichnungen dargestellten Ausführungsbeispiels näher erläutert. Es zeigen:
- Fig. 1: in perspektivischer Ansicht den schematischen Aufbau eines bekannten Baugruppenträgers,
- Fig. 2: in perspektivischer Draufsicht auf ein für einen Baugruppenträger verwendbares Bodenteil nach der Erfindung,
- Fig. 3: in vergrößerter perspektivischer Darstellung den Eckbereich X des Bodenteils nach Fig. 2,
- Fig. 4: den Eckbereich X in Draufsicht,
- Fig. 5: ein Federelement zum Aufstecken auf einen Einführsteg einer Führungsschiene,
- Fig. 6: das Federelement nach Fig. 5 auf die Stirnseite gesehen,
- Fig. 7: eine perspektivische Teildraufsicht mit einem auf einen Einführsteg aufgesteckten und mit dem Bodenteil verrasteten Federelement,
- Fig. 8: die Draufsicht auf den in Fig. 7 gezeigten Bereich des Bodenteils,

- Fig. 9: eine Teilansicht mit dem auf einem Einführsteg und dem Bodenteil verrasteten Federelement,
- Fig. 10: einen Baugruppenträger in perspektivischer Ansicht,
- Fig. 11: einen vergrößerten Ausschnitt der linken Bodenseite des Baugruppenträgers gemäß Fig. 10 und
- Fig. 12: einen Vertikalschnitt durch den Baugruppenträger gemäß Fig. 10.

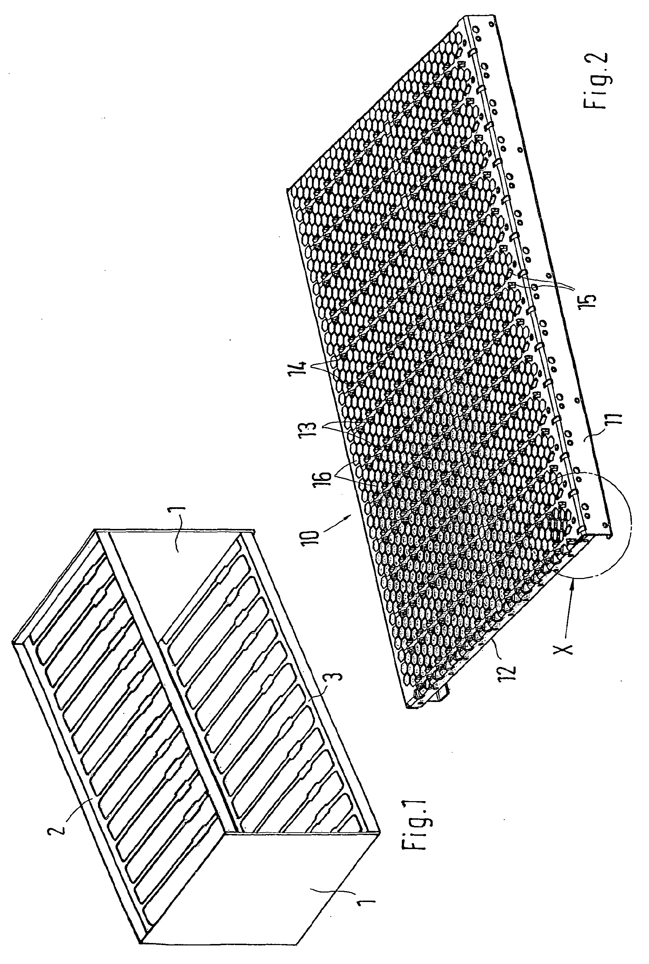

Die schematische Ansicht nach Fig. 1 zeigt einen Baugruppenträger gemäß dem Stand der Technik mit zwei Seitenwänden 1, die die Höhe festlegen. Das Kopfteil 2 und das Bodenteil 3 vervollständigen den Baugruppenträger und bestimmen dessen Breite. Wie der Fig. 1 zu entnehmen ist, stellen das Kopfteil 2 und das Bodenteil 3 einstückige Teile dar, die mehrere nebeneinander angeordnete und in Einschubrichtung ausgerichtete Führungsschienen aufweisen. Ein umtaufender Rahmen verbindet die Führungsschienen an der Vorder- und an der Rückseite des Baugruppenträgers. Dabei können das Kopfteil 2 und das Bodenteil 3 identisch ausgebildet und um 180° verdreht in dem Baugruppenträger eingesetzt sein, wobei die Führungsschienen am Kopfteil 2 nach unten offen und am Bodenteil 3 nach oben offen sind, um eine Leiterplatte einer Steckbaugruppe aufnehmen und führen zu können. Wie bereits ausgeführt, sind derartig ausgebildete Kopf- oder Bodenteile aufgrund der konstruktiven Ausgestaltung der Führungsschienen nicht einfach und kostengünstig herzustellen.

Um diesen Nachteil zu vermeiden, verwendet der Baugruppenträger nach der Erfindung Kopf- oder Bodenteile 10 nach Fig. 2, die als einfache Stanz-Biegeteile in einem einfachen, unkomplizierten Vorgang herstellbar sind, da praktisch nur in Stanzrichtung auch die wesentlichen Biegevorgänge durchgeführt werden können.

Aus Stabilitätsgründen ist das plattenförmige, mit vielen Durchbrüchen 16 versehene Kopf- oder Bodenteil 10 mit abgekanteten als Ränder ausgebildeten Seitenwände 11 und 12 verstärkt.

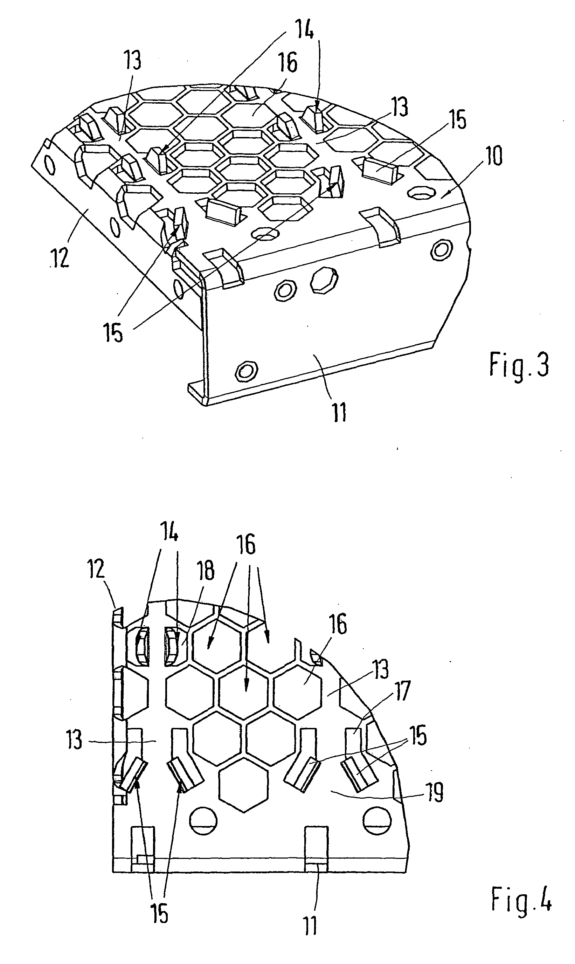

Wie mit den vergrößerten Ansichten nach Fig. 3 und 4 gezeigt ist, werden Führungsbahnen 13 mit hochgekanteten Führungsstegen 14 als Führungsschienen gebildet, die von der Vorderseite zur Rückseite des Kopf- oder Bodenteils 10 ausgerichtet sind. Auf der Vorderseite bildet ein Paar von Einführstegen 15 eine Einführaufnahme pro Führungsschiene. Außerhalb der Führungsbahnen 13 ist das Kopf- oder Bodenteil 10 als Lochplatte mit Durchbrüchen 16 versehen.

Wie aus den Fig. 3 und 4 deutlich zu erkennen ist, sind pro Führungsschiene zwei Reihen von Führungsstegen 14 vorgesehen, die einfach ausgestanzt und hochgekantet sind. Dabei verbleibt neben dem Führungsstege 14 eine Aussparung 18. Die Durchbrüche 16 sind regelmäßige Sechsecke und schließen wabenartig aneinander, so dass ein Großteil der Fläche des Kopf- oder Bodenteils 10 zwischen den geschlossenen Führungsbahnen 13 zwischen den beiden Reihen von Führungsstegen 14 pro Führungsschiene offen bleibt und für die Belüftung und/oder Kühlung der Steckbaugruppen im Baugruppenträger ausgenützt werden kann.

Die Durchbrüche 18 dienen ebenfalls der Belüftung und/oder Kühlung. Dementsprechend kann Luft zwischen der Ober- und der Unterseite des Kopf- oder Bodenteils 10 durch die Durchbrüche 16 und Aussparungen 18 zirkulieren. Dabei wird die VerlustWärme aus dem Baugruppenträger-Innenraum aufgenommen und abtransportiert.

Eine Besonderheit ist in den Fig. 3 und 4 ebenfalls deutlich erkennbar. Die Führungsstege 14 der beiden Reihen einer Führungsschiene stehen in Einschubrichtung paarweise einander gegenüber und sind leicht so geneigt, dass der Abstand von der Führungsbahn 13 beginnend zum freien Ende der Führungsstege 14 hin leicht zunimmt. Im Bereich der Führungsbahn 13 ist dieser Abstand an die Dicke der Leiterplatte der Steckbaugruppe angepasst.

Damit wird die Einschubreibung für die Steckbaugruppen klein gehalten. Zudem wird ein Verhaken der Steckbaugruppe an den Führungsstegen 14 verhindert.

Auf der Einführseite bildet ein Paar von Einführstegen 15 eine Einführöffnung als eine Art Einführschräge. Dieses Paar von Einführstegen 15 am Anfang der Führungsschienen ist zusätzlich zu ihrer Neigung nach ihren Außenseiten (wie die Führungsstege 14) schräg ausgestanzt, so dass die einander zugekehrten Seitenflächen in Einschubrichtung in einem spitzen Winkel zueinander stehen. Daher ist ihr Abstand an der Anfangsfront größer als an der Endfront, so dass die sich verengende Einführaufnahme 19 gebildet wird. Diese Einführaufnahme 19 geht am Ende in die Dicke der Leiterplatte der Steckbaugruppe über. Die Einführstege 15 sind ebenfalls aus dem Kopf- oder Bodenteil 10 ausgestanzt, wobei die doppelte Schrägstellung der Einführstege 15 eine vergrößerte Stanzaufnahme 17 voraussetzt (Fig. 4).

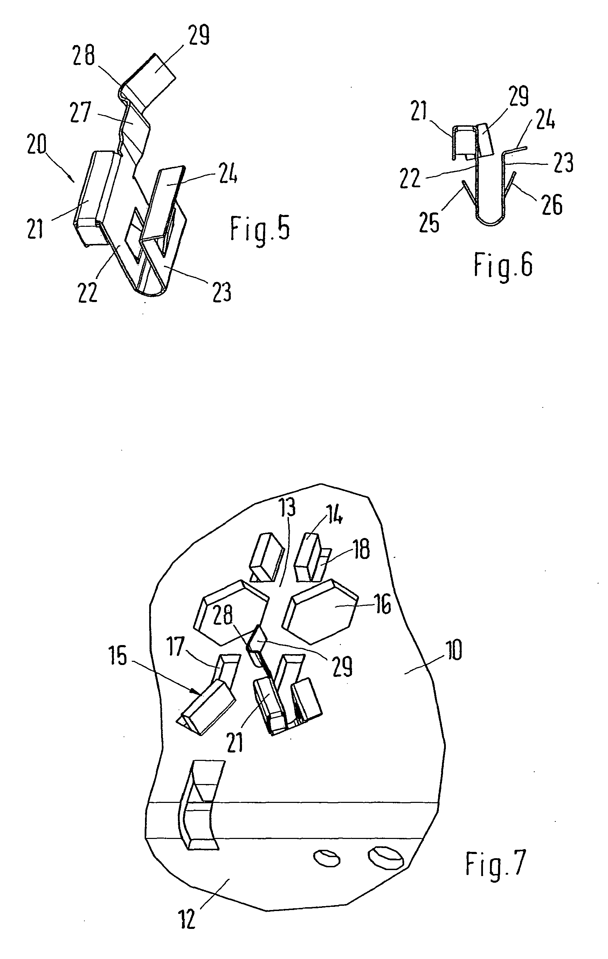

Anhand der Fig. 5 bis 9 wird ein Beispiel gezeigt, wie das Kopf- oder Bodenteil 10 mit einem Federelement 20 nach Fig. 5 die Kontaktierung zwischen den Leiterplatten der Steckbaugruppen und dem Kopf- oder Bodenteil 10 hergestellt und das Federelement 20 mit dem verwendeten Einführsteg 15 verbunden werden kann.

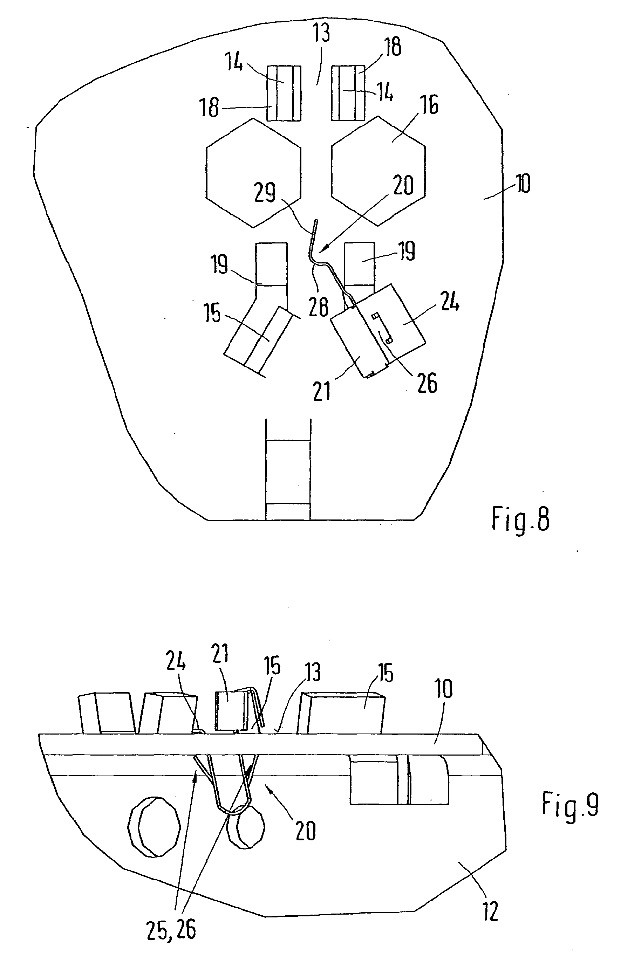

Das Federelement 20 weist eine Aufsteckhaube 21 auf, die auf den Einführsteg 15 einer Führungsschiene aufgesteckt werden kann. An die eine Längswand der Aufsteckhaube 21 schließt sich ein U-förmiges Steckteil mit den Schenkeln 22 und 23 an (Fig. 6), das in die Stanzaufnahme 17 des Einführsteges 15 einrastet (Fig. 9). Dabei stützen sich die an den Schenkeln 22 und 23 ausgestanzten Rastlappen 25 und 26 auf der Oberseite des Kopfteils bzw. Unterseite des Bodenteils 10 ab. Der Endabschnitt 24 des Schenkels 23 begrenzt die Einsteck- und Einrastbewegung, so dass das Federelement 20 fest und unkippbar auf dem Einführsteg 15 sitzt. An der Aufsteckhaube 21 des Federelementes 20 ist ein Federblatt 27 angebracht, das wie die Kontaktfeder in die Führungsschiene ragt, wie die Fig. 7 und 8 zeigen. Dabei ragt eine am Federblatt 27 gebildete Anlagekontaktstelle 28 am weitesten in die Führungsschiene.

Wird eine Leiterplatte einer Steckbaugruppe eingeschoben, dann wird das Federblatt 27 ausgelenkt und nur die Anlagekontaktstelle 28 stellt die elektrische Verbindung her. Der Endabschnitt 29 des Federblattes 27 steht als Auszugsschräge im Abstand zur Leiterplatte, so dass dieser beim Herausziehen der Steckbaugruppe nicht mit derselben verhaken kann. Das Federelement 20 kann verschieden ausgebildet werden, so dass es entweder auf den linken oder rechten Einführsteg 15 einer Führungsschiene aufgebracht werden kann

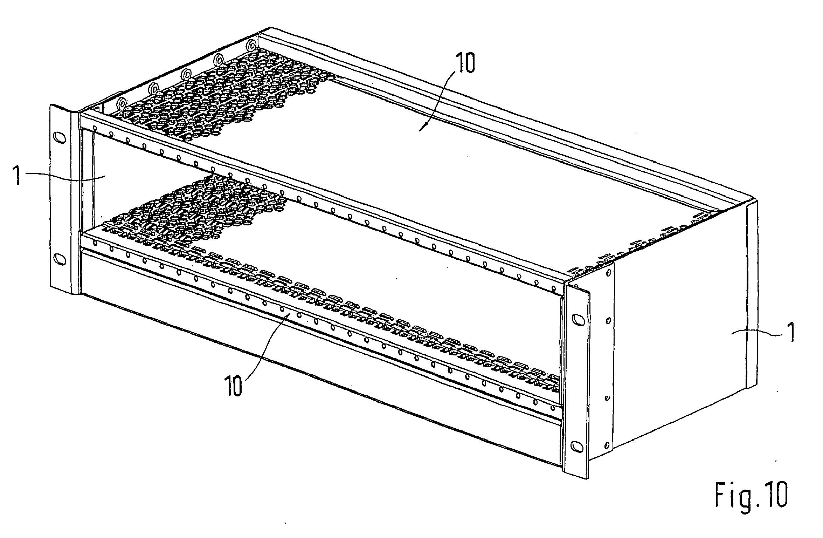

Die Fig. 10 zeigt einen Baugruppenträger mit zwei Seitenteilen 1 und einem Kopf-und einem Bodenteil 10.

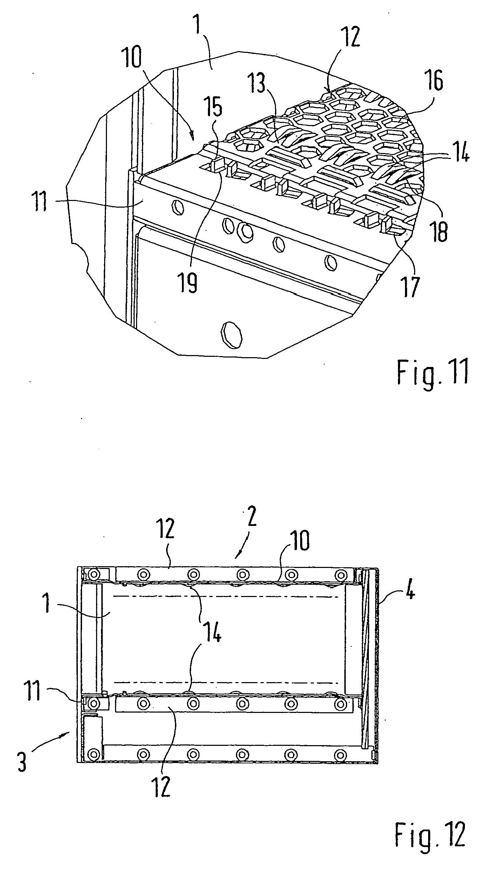

Die Gestaltung des identisch zu dem Kopfteil 10 ausgebildeten Bodenteils 10 ergibt sich aus der Fig. 11.

Wie diese Darstellung erkennen lässt, ist das Bodenteil 10 ähnlich gestaltet wie das gemäß den Fig. 2 bis 9. Eine Abweichung ergibt sich in Gestaltung der Führungsstege 14. Wie die Fig. 11 erkennen lässt sind die Führungsbahnen 13 von brückenartigen Führungsstegen 14 begrenzt. Diese sind im Anbindungsbereich zu dem Bodenteil 10 mit im flachen Winkel in Richtung der Führungsbahnen 13 verlaufenden Auflaufschrägen versehen. Die Auflaufschrägen sind mit einem Brückenabschnitt verbunden. Die Auflaufschrägen verhindern zuverlässig ein Verhaken der Leiterplatte beim Einschieben bzw. Ausziehen der Leiterplatte.

Erfindungsgemäß sind die aus Stahlblech bestehenden Kopf- und Bodenteile 10 gemäß den Fig. 1 bis 12 mit einer Oberflächenbeschichtung aus elektrisch isolierendem Material versehen.

Beispielsweise kann eine Pulverlackbeschichtung verwendet sein. Dabei lässt die Oberflächenbeschichtung Bereiche des Kopf- oder Bodenteils 10 frei, die für eine elektrische Kontaktierung benötigt werden. Beispielsweise sind die Seitenwände 11 und 12 freigestellt.

Daran können die Seitenwände 1, eine Rückwand 4 bzw. Frontbauteile auf ein einheitliches elektrisches Potential gelegt bzw. hier eine EMV-Kontaktierung vorgenommen werden.

Bedarfsweise können auch die Einführstege 15 zumindest bereichsweise beschichtungsfrei gehalten werden, um eine Kontaktierung des Federelementes 20 zu ermöglichen.

## Patentansprüche

1. Kopf- oder Bodenteil eines Baugruppenträgers mit nebeneinander angeordneten und in Einschubrichtung ausgerichteten Führungsschienen zur Aufnahme einer Leiterplatte einer Steckbaugruppe, wobei die Führungsschienen durch einstückige Führungselemente des Kopf- oder Bodenteils gebildet sind, und wobei das Kopf- oder Bodenteil zumindest bereichsweise aus einem elektrisch leitenden Material besteht,
**dadurch gekennzeichnet,**
**dass** das Kopf- oder Bodenteil (10) zumindest teilweise im Bereich der Führungsschiene mit einer Oberflächenbeschichtung aus elektrisch nicht leitendem Material versehen ist.

2. Kopf- oder Bodenteil nach Anspruch 1,
**dadurch gekennzeichnet,**
**dass** die Oberflächenbeschichtung stoffschlüssig mit der Oberfläche des Boden- und/oder Kopfteiles (10) verbunden ist.

3. Kopf- oder Bodenteil nach Anspruch 2,
**dadurch gekennzeichnet,**
**dass** die Oberflächenbeschichtung als Pulverbeschichtung oder als Wirbelsinterbeschichtung ausgebildet ist.

4. Kopf- oder Bodenteil nach einem der Ansprüche 1 bis 3,
**dadurch gekennzeichnet,**
**dass** die Führungselemente pro Führungsschienen aus jeweils zwei in Einschubrichtung verlaufenden beabstandeten Reihen von mehreren Führungsstegen (14) gebildet sind, die aus einem plattenförmigen Kopf- oder Bodenteil (10) ausgestanzt und zur Unterseite des Kopfteils oder zur Oberseite des Bodenteils vorstehend abgekantet sind,
**dass** der Abstand der Führungsstege (14) der Führungsschienen an die Dicke der Leiterplatten der Steckbaugruppen angepasst ist und
**dass** das Kopf- oder Bodenteil (10) zwischen den Reihen von Führungsstegen (14) der Führungsschienen Führungsbahnen (13) für die Leiterplatten der Steckbaugruppen bilden.

5. Kopf- oder Bodenteil nach Anspruch 4,
**dadurch gekennzeichnet,**
**dass** die Führungsbahnen (13) und die Führungsstege (14) an ihren der Führungsbahnen (13) zugewandten Seite mit der Oberflächenbeschichtung versehen sind.

6. Kopf- oder Bodenteil nach Anspruch 4 oder 5,
**dadurch gekennzeichnet,**
**dass** sich der Abstand zwischen den Führungsstegen (14) zu den Endkanten der Führungsstege (14) hin leicht vergrößert.

7. Kopf- oder Bodenteil nach einem der Ansprüche 4 bis 6,
**dadurch gekennzeichnet,**
**dass** außerhalb der Führungsbahnen (13) und Führungsstege (14) das Kopf-oder Bodenteil (10) mittels Durchbrüchen (16) lochblechartig ausgebildet ist.

8. Kopf- oder Bodenteil nach einem der Ansprüche 1 bis 7,
**dadurch gekennzeichnet,**
**dass** die Seiten des plattenartigen Kopf- oder Bodenteils (10) mittels abgekanteter Seitenwände (11,12) versteift ist.

9. Kopf- oder Bodenteil nach Anspruch 8,
**dadurch gekennzeichnet,**
**dass** die Seitenwände (11,12) zumindest bereichsweise von der Oberflächenbeschichtung freigestellt sind.

10. Kopf- oder Bodenteil nach einem der Ansprüche 1 bis 9,
**dadurch gekennzeichnet,**
**dass** das Kopf- oder Bodenteil (10) identisch ausgebildet und um 180° verdreht im Baugruppenträger eingebaut sind.

11. Kopf- oder Bodenteil nach einem der Ansprüche 4 bis 10,
**dadurch gekennzeichnet,**
**dass** die Führungselemente (14) der Führungsbahnen (13) paarweise einander gegenüberstehend angeordnet sind.

12. Kopf- oder Bodenteil nach einem der Ansprüche 4 bis 11,
**dadurch gekennzeichnet,**
**dass** das der Einführseite zugewandte erste Paar der Führungsstege einer Führungsbahn (13) als Einführstege (15) ausgebildet ist und die Einführstege (15) mit den einander zugekehrten Seiten im spitzen Winkel zueinander stehen, der sich zur Einführseite hin öffnet und
**dass** die Einführstege (15) der Führungsbahnen (13) damit eine mit Einführschräge versehene Einführaufnahme (19) bilden.

13. Kopf- oder Bodenteil nach einem der Ansprüche 1 bis 12,
**dadurch gekennzeichnet,**
**dass** es als Stanz-Biegeteil aus einem Blechzuschnitt hergestellt ist.

14. Kopf- oder Bodenteil nach einem der Ansprüche 1 oder 13,
**dadurch gekennzeichnet,**
**dass** auf einen der Einführstege (15) ein Federelement (20) aufsetzbar ist, das mit einem Federblatt (27) in die Führungsschiene ragt.

15. Kopf- oder Bodenteil nach Anspruch 14,
**dadurch gekennzeichnet,**
**dass** das Federelement (20) eine Aufsteckhaube (21) aufweist, die auf den Querschnitt des Einführelementes (25) angepasst ist.

16. Kopf- oder Bodenteil nach Anspruch 15,
**dadurch gekennzeichnet,**
**dass** sich an die Aufsteckhaube (21) des Federelementes (20) ein U-förmiges Steckteil anschließt, das zwei Schenkel (22, 23) mit Rastlappen (25, 26) aufweist, und
**dass** das Steckteil in die beim Ausstanzen und Abkanten des Einführsteges (15) entstehende Stanzaufnahme (17) des Kopf- oder Bodenteils (10) einrastbar ist.

17. Kopf- oder Bodenteil nach Anspruch 16,
**dadurch gekennzeichnet,**
**dass** das Steckteil in einen abgewinkelten Endanschlag (24) ausläuft, der die Einsteckbewegung des Steckteils und die Aufsteckbewegung der Aufsteckhaube (21) begrenzt.

18. Kopf- oder Bodenteil nach einem der Ansprüche 14 bis 17,
**dadurch gekennzeichnet,**
**dass** das Federblatt (27) eine Anlagekontaktstelle (28) zur Leiterplatte der Steckbaugruppe bildet und
**dass** das Federblatt (27) nach der Anlagekontaktstelle (28) in einen eine Anziehschräge bildenden Endabschnitt (29) übergeht.
